# EUROPEAN PATENT SPECIFICATION

(11) **EP 0 359 342 B1**
(45) Date of publication and mention of the grant of the patent: **06.05.1998**
(21) Application number: 89202373.0
(22) Date of filing: 07.08.1985
(51) Int. Cl.: G03F 7/38, G03F 7/20

(54) **Process for forming a layer of patterned photoresist**
Verfahren zur Herstellung von gemusterten Photoschutzlackschichten
Procédé pour la fabrication d'une couche photoréserve texturée

(30) Priority: 13.08.1984 US 639875
(43) Date of publication of application: 21.03.1990
(62) Divisional of application: 85903964.6
(73) Proprietor: NCR International, Inc., Dayton, Ohio 45479 (US); HYUNDAI ELECTRONICS AMERICA, Milpitas, California 95035 (US); Symbios, Inc., Fort Collins, Colorado 80525 (US)
(72) Inventor: Maheras, George, Fort Collins, C0 80526 (US); Hayworth, Hubert O., Fort Collins, C0 80524 (US); Gulett, Michael R., Fremont, CA 94538 (US)
(74) Representative: Gill, David Alan

## Description

### Technical Field

This invention relates to processes of the kind for forming a layer of patterned photoresist on a substrate, including the step of forming on said substrate a layer of polymeric photoresist material.

A particular application of the invention is to photolithographic barrier masking as applied to semiconductor process technology.

### Background Art

The production of large scale integrated circuit semiconductor devices by the formation of patterned photoresist, interchangeably referred to herein as a resist, barrier layers on semiconductor wafers, interchangeably referred to herein as subtrates, requires that such photoresist layers be sufficiently precise in shape and location to allow the reliable manufacture of extremely small structural configurations, and further that such layers be free of spurious hole defects. It is commonly known that the presence of such "pinhole" defects can when masking dielectric layers expose such layers to unwanted etching therethrough, and consequential short circuit paths following metallization. Because a defect in a single conductive path or device can cause a complete integrated circuit chip, consisting of thousands of such devices, to be inoperative, the elimination of such flaws has given rise to a variety of techniques aimed at holding their occurrence to an absolute minimum. Subsequent discussions will be concerned mainly with the use of such barrier layers as etching barriers; however, the limitations of the prior art and the advantages of the present invention thereover are equally applicable with respect to the common practice of using such patterns as selective masks for deposition, ion implantation, diffusion, lift-off, etc. operations.

Positive photoresists, those presently preferred for semiconductor processing, are usually formed from a polymer dissolved in an appropriate carrier solvent to create a lacquer, which lacquer is applied by conventional spin-on techniques to form a thin solid layer over a substrate after the carrier solvent is removed by evaporation. A subsequent selective exposure of the resist layer to depolymerizing wavelength radiation passed through a patterned mask, or alternatively by means of a direct projection of such actinic radiation, causes local depolymerization of the irradiated resist to the form of a monomer. Subsequent immersion of the resist coated substrate into a developer solvent having the ability to dissolve the resulting monomer, while having no substantial attack rate on the unexposed polymer, causes a retention of the desired polymer photoresist pattern. Alternatively, the selectively exposed layer may be "dry developed" by exposure to ionic plasmas of certain gases having similar selective dissolving characteristics.

For maximum resolution, i.e. to produce the smallest apertures in the resist, the thickness of the resist layer must be held to values of 500 nanometers or less. Unfortunately, resist barriers this thin very frequently exhibit flaws, in the nature of random pinhole defects. Such flaws arise from a variety of sources, including dust particles in the photolithographic system and mask defects.

One particular photoresist resolution problem arises because of the multi-layered nature of present integrated circuit semiconductor devices. The surface topography of integrated circuit wafers in the latter stages of fabrication is far from planar, being characterized by a multiplicity of steps each of the general order of several hundred nanometers, such steps representing the edges of metallizations, nitride capping layers, and a variety of other layer boundaries which are inherent to the particular fabrication processes used. To achieve the resolution required for the small geometries presently sought, focus and fringing defects must be minimized by using a highly planar photoresist surface during exposure. If the photoresist layer is too thin, it will generally replicate the surface topography of the substrate. Thus, it becomes necessary in the latter stages of fabrication to employ photoresist films of substantially increased thickness to planarize the surface topography. Such "planarizing" layers are typically chosen to be two thousand to three thousand nanometers thick.

To achieve maximum pattern resolution in a barrier produced from such a thick resist layer, it is known to form a three layer masking structure, using a relatively thick photoresist layer of two microns thickness or greater, covered by multiple thin supplemental barrier layers. In practice the top layer is a thin photoresist and the next layer down is formed of an inorganic material such as silicon dioxide. By following a complex series of pattern exposures, etches, and two separate photoresist development steps, a masking structure of adequate resolution is achieved to provide the substrate etching barrier. Figs. 2A-2C show such a known system, which will be discussed in detail hereinafter. A detailed discussion of this technique also appears in the article "Multilayer Resists for Fine Line Optical Lithography" by Ong et al., Solid State Technology, p. 155-160 (June 1984).

The above mentioned processes are not only quite complex but they inherently require multiple manual handling operations involving additional costs and likeihood of damage. Wafer damage occurring in the latter stages of processing is a significant concern, since the individual wafers have become quite valuable by this point.

From EP-A-0,103,337, there is known a method of manufacturing a semiconductor device in which a photosensitive lacquer layer which includes a polymeric material and a sensitizer with a diazo group and a ketone group is formed on a substrate. The lacquer layer is then subjected to a selective patterning irradiation which, in one embodiment, renders the irradiated portions of a superficial layer of the lacquer layer developable. After the patterning irradiation but before development, the lacquer layer is subjected to an intermediate treatment which includes first and second irradiations. During the first irradiation an ester compound is formed in a top layer of the parts of the lacquer layer which were not irradiated by the patterning irradiation. By a second irradiation at least a part of the sensitizer is then converted into an acid in the parts of the lacquer layer below the superficial layer. Thus, differences in solubility when the lacquer layer is developed are obtained in the parts of the lacquer layer which were not exposed during the patterning irradiation in the direction of the thickness of the lacquer layer.

It is an object of the present invention to provide a process of the kind specified, whereby a high resolution patterned photoresist layer may be provided in a simple manner.

Therefore, according to the present invention, there is provided a process for forming a layer of patterned photoresist on a substrate including the steps of: forming on said substrate a layer of polymeric photoresist material, and converting selected, relatively thin regions adjacent to the surface of said layer to monomeric form by exposing said selected regions to depolymerizing wavelength energy; characterized by the steps of: selectively hardening said layer to form from a surface region of said polymeric photoresist material a surface layer which is substantially opaque to further depolymerizing wavelength energy without materially affecting said selected regions; exposing said layer to depolymerizing energy to which said surface layer is substantially opaque and using said surface layer as a mask, thereby causing the conversion to monomeric form of regions of said layer extending from said selected regions through the full thickness of said layer; and developing out the monomeric material.

It has been found that certain hardening techniques, which can render certain polymeric positive photoresists insoluble in the solvents in which they would otherwise be dissolved, are selectively operable on only the polymeric portions of an exposed but not yet developed layer, so that it is not necessary to develop the layer to remove the exposed monomer from it before hardening, as was heretofore the practice. Such selective hardening techniques include properly controlled overall exposure to plasmas of certain gases or to positive ion bombardment, and are postulated to include ultraviolet irradiation over a range of wavelengths which crosslink but do not depolymerize.

The term "actinic" will be employed hereinafter exclusively to describe normal depolymerizing radiation.

The invention takes advantage of the fact that the selectively hardened and crosslinked surface regions of the photoresist layer were found to act as a screen during subsequent exposure to actinic radiation, which radiation would otherwise depolymerize all underlying first layer polymer. In particular, the actinic radiation masking function of the hardened areas in the photoresist layer prevents depolymerization of the underlying photoresist layer.

Examples of commercially available photoresist materials exhibiting the aforementioned selective hardening features are type AZ4210 positive photoresist manufactured by American Hoerch Corporation and type HPR204 positive photoresist manufactured by Hunt Chemical Company.

According to an embodiment of the invention as applied to the production of patterns of good resolution on relatively thick "planarizing" photoresist layers, a layer of chosen thickness is applied and then exposed to an actinic radiation pattern sufficiently long to depolymerize only the surface regions of the layer. The photoresist film is then selectively hardened by any of the above mentioned methods, thereby forming on each unexposed polymeric region an actinic radiation opaque masking layer of hardened polymer. Thereby the original mask pattern is replicated as a high resolution pattern on the surface of the thick photoresist layer. A subsequent general "flooding" exposure by actinic ultraviolet radiation selectively depolymerizes only the unmasked regions of the thick photoresist layer lying directly beneath the formerly exposed surface areas.

According to the practice of the present invention, the complex series of procedures outlined hereinabove for producing high resolution patterns in thick, planarizing photoresist layers is rendered unnecessary. Additionally, only a single photoresist layer need be laid down, as contrasting with the conformable mask systems according to the prior art.

An alternative approach is disclosed in U.S. Patent No. 4,352,820 issued to Howard et al., which discloses the use of a two layer resist composition wherein the upper thin layer of resist is used as a high resolution mask to control electron beam removal of the lower photoresist layer. Backscattered electrons provide a measure of undercut to control the resolution of the system. Because of the nature of the undercutting process, a basic restriction on unsupported spans between apertures is imposed (column 4, lines 60-63), a limitation not present in the process of the present invention.

### Brief Description of the Drawings

One embodiment of the invention will now be described by way of example with reference to the accompanying drawings in which:

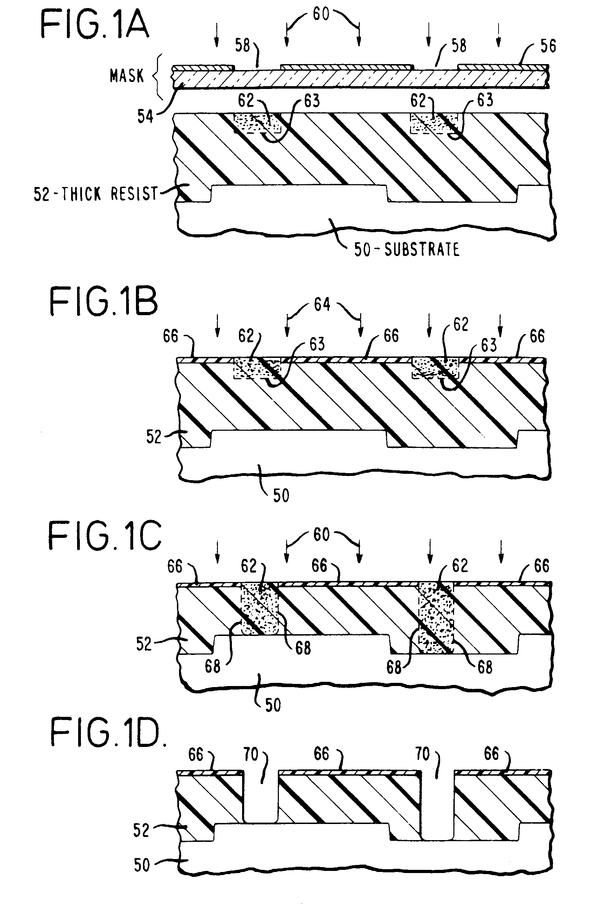

Figs. 1A-1D are cross-sectional views of a substrate subjected to a single, planarizing layer photoresist process according to an embodiment of the invention, sowing local surface exposure of the desired regions of the photoresist, selective hardening of the outer surface of the polymeric photoresist to render it selectively ultraviolet opaque, flooding of the structure to extend the depolymerized surface layer down to the substrate, and the resulting structure after development, respectively; and
Figs. 2A-2C depict the corresponding steps of a known three layer process used to accomplish the same end result as shown in Fig. 1D, showing initial pattern imaging of an upper photoresist layer, use of a developed pattern in this layer to etch apertures in an intermediate inorganic layer, and the resulting final structure after the apertures in the intermediate layer have been used as a mask for selective removal of photoresist in the lower layer, respectively.

### Best Mode for Carrying Out the Invention

The selective hardening feature of certain processes on certain positive photoresists, as mentioned hereinabove, permits substantial improvement in the fabrication of high resolution pinhole-free photoresist mask patterns using thick "planarizing" photoresist layers. In more detail, it has been found that if a solid polymeric film of positive photoresist such as the type AZ4210 manufactured by American Hoechst Corporation or type HPR204 manufactured by Hunt Chemical Company is locally exposed by standard actinic radiation of wavelength about 400 nanometers, thereby converting the exposed areas from polymeric to monomeric form, and next generally exposed overall to a discharge plasma of a chosen gas or mixture of gases, two things occur: first , the surface of the polymeric regions is rendered substantially insoluble in the polymeric photoresist carrier solvent, while the monomeric regions remain soluble in the standard sodium hydroxide based developer used to selectively extract the monomer, i.e. to develop the pattern images; and second, the polymeric regions so treated or "selectively hardened" are substantially opaque to subsequent exposures of actinic radiation which would normally cause the depolymerization thereof.

Such selective hardening has been accomplished by using nitrogen, helium or argon plasmas, and by other forms of positive ion bombardment, e.g. sputtering bombardment and ion implant, or high energy irradiation using ultraviolet light having a wavelength which will crosslink the polymer without converting it to the monomeric form.

Figs. 1A through 1D show the use of the actinic radiation screening action of selectively crosslinked portions of a photoresist layer as applied to the fabrication of high resolution patterns on a thick planarizing photoresist layer. In Fig. 1A a topologically nonplanar substrate 50 coated with a thick layer of photoresist of thickness of the order of 2,400 nanometers is exposed to actinic radiation 60 through a mask composed of plate 54 having an opaque masking layer 56 with apertures 58-58 therein. The intensity and duration of exposure are controlled so that corresponding monomeric regions 62-62 are formed only to a depth of preferably 400 manometers, as indicated by boundaries 63-63. Although the pattern of monomeric latent image regions 62-62 of Fig. 1A are shown as produced with a contact type masking, it is with equal merit applicable to projected actinic images.

The photoresist layer 52 is next subjected (Fig. 1B) to exposure to any of the selective hardening agents 64 previously described, thus producing crosslinked surface areas 66 at all points except over the monomeric regions 62 on the surface of the resist layer 52. At this point a mask for actinic radiation is "fixed" over the entire top surface of the resist layer 52.

Since the crosslinked surface portions 66-66-66 are substantially opaque to actinic radiation, a subsequent general flooding or blanket exposure (Fig. 1C) to actinic radiation 60-60 causes only the original monomeric regions to be fully exposed. The flooding exposure is selected to be of sufficient duration and intensity to ensure that the polymeric regions of the photoresist layer 52, below the shallow monomeric regions 63-63 in Fig. 1B, are fully converted to monomeric regions, having boundaries 68-68, down to the substrate 50. A subsequent conventional development removes these monomeric layers, as shown in Fig. 1D, to leave etching apertures 70-70, thereby completing the fabrication of the photoresist masking layer.

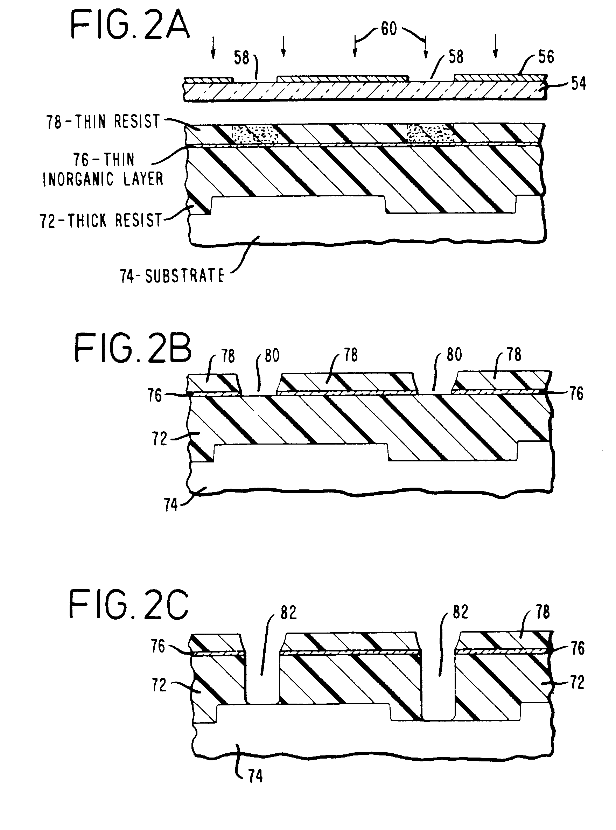

This is to be contrasted with a known process for forming a three-layer mask, as illustrated in Figs. 2A-2C. Fig. 2A shows a thick planarizing photoresist layer 72, composed of PMMA or similar material, deposited over a substrate 74, and over which is deposited a thin supplemental etching barrier layer 76. This barrier layer is typically composed of deposited silicon dioxide or silicon nitride, with a thickness of about 50 to 100 nanometers. Over this inorganic barrier layer is applied the high resolution photoresist film 78, with a thickness in the range of 500 nanometers. This upper layer 78 is exposed in conventional manner first to actinic radiation 60-60 patterned by opaque layer 56 on plate 54, and then to a development cycle. In this way, a high resolution aperture patttern is formed in photoresist layer 78, exposing selected regions of the underlying silicon dioxide or nitride barrier layer 76. The barrier layer 76 is then selectively etched away (Fig. 2B) using the top photoresist layer 78 as the etching barrier, to form a high resolution pattern of apertures 80-80 in the thin barrier layer 76. Next the aperture pattern 80-80 in the barrier layer 76 is itself used as a mask for selective patterning lower photoresist layer 72 (Fig. 2C), preferably by direct anisotropic plasma etching, or alternatively by conventional photolithographic processing, to produce the deep aperture pattern 82-82. The resulting mask barrier structure is then ready to govern the etching of the substrate.

It will therefore be seen that the simple single-layer process now disclosed can be used to produce a mask pattern having a resolution comparable to that produced by the known complex multilayer process.

## Claims

1. A process for forming a layer of patterned photoresist on a substrate (50) including the steps of: forming on said substrate (50) a layer of polymeric photoresist material (52), and converting selected, relatively thin regions (62) adjacent to the surface of said layer (52) to monomeric form by exposing said selected regions (62) to depolymerizing wavelength energy; characterized by the steps of: selectively hardening said layer (52) to form from a surface region of said polymeric photoresist material a surface layer (66) which is substantially opaque to further depolymerizing wavelength energy without materially affecting said selected regions (62); exposing said layer (52) to depolymerizing energy to which said surface layer (66) is substantially opaque and using said surface layer (66) as a mask, thereby causing the conversion to monomeric form of regions of said layer (52) extending from said selected regions (66) through the full thickness of said layer (52) ; and developing out the monomeric material.

2. A process according to claim 1, characterized in that said step of further exposing is effected with a blanket exposure of said layer (52).

## Patentansprüche

1. Verfahren zur Herstellung einer Schicht aus strukturiertem Fotolack auf einem Substrat (50), umfassend die folgenden Schritte: Ausbilden einer Schicht aus polymerem Fotolackmaterial (52) auf dem genannten Substrat (50) und Umwandeln gewählter, relativ dünner Zonen (62) an der Oberfläche der genannten Schicht (52) in eine monomere Form durch Aussetzen der genannten gewählten Zonen (62) einer Energie mit einer depolymerisierenden Wellenlänge; gekennzeichnet durch die folgenden Schritte: selektives Härten der genannten Schicht (52), um von einer Oberflächenzone des genannten polymeren Fotolackmaterials eine Oberflächenschicht (66) zu bilden, die für weitere Energie mit depolymerisierender Wellenlänge im wesentlichen undurchlässig ist, ohne die genannten gewählten Zonen (62) materiell zu beeinflussen; Aussetzen der genannten Schicht (52) depolymerisierender Energie, gegenüber der die genannte Oberflächenschicht (66) im wesentlichen undurchlässig ist, und Benutzen der genannten Oberflächenschicht (66) als Maske, um auf diese Weise die Umwandlung von Zonen der genannten Schicht (52) in eine monomere Form zu bewirken, die von den genannten gewählten Zonen (66) über die gesamte Dicke der genannten Schicht (52) verlaufen; und Herausentwickeln des monomeren Materials.

2. Verfahren nach Anspruch 1, dadurch gekennzeichnet, daß der genannte Schritt des weiteren Aussetzens mit einer flächendeckenden Aussetzung der genannten Schicht (52) bewirkt wird.

## Revendications

1. Procédé pour former une couche de photorésine formant un motif sur un substrat (50) comprenant les étapes consistant à : former sur ledit substrat (50) une couche de matériau photorésine polymère (52), et convertir des zones choisies (62), relativement minces, adjacentes à la surface de ladite couche (52) en une forme monomère en exposant lesdites zones choisies (62) à une énergie d'une longueur d'onde de dépolymérisation ; caractérisé par les étapes consistant à : durcir sélectivement ladite couche (52) pour former, à partir d'une zone de surface dudit matériau photorésine polymère, une couche de surface (66) qui est sensiblement opaque à une énergie d'une longueur d'onde de dépolymérisation supplémentaire sans affecter matériellement lesdites zones choisies (62) ; exposer ladite couche (52) à une énergie de dépolymérisation à laquelle ladite couche de surface (66) est sensiblement opaque et utiliser ladite couche de surface (66) comme masque, de manière à provoquer la conversion en forme monomère de zones de ladite couche (52) s'étendant depuis lesdites zones choisies (66) à travers toute l'épaisseur de ladite couche (52) ; et développer le matériau monomère.

2. Procédé selon la revendication 1, caractérisé en ce que ladite étape d'exposition supplémentaire est mise en oeuvre avec une exposition de l'ensemble de ladite couche (52).
